# EUROPÄISCHE PATENTSCHRIFT

(11) **EP 0 351 905 B1**
(45) Veröffentlichungstag und Bekanntmachung des Hinweises auf die Patenterteilung: **15.12.1993**
(21) Anmeldenummer: 89201815.1
(22) Anmeldetag: 10.07.1989
(51) Int. Cl.: C23C 16/44, C23C 16/50, C23C 14/24, C23C 16/48

(54) **Verfahren zur Herstellung von Festkörpern**
Solid bodies production process
Procédé de production de corps solides

(30) Priorität: 16.07.1988 DE 3824273
(43) Veröffentlichungstag der Anmeldung: 24.01.1990
(73) Patentinhaber: Philips Patentverwaltung GmbH, 22335 Hamburg (DE); Philips Electronics N.V., 5621 BA Eindhoven (NL)
(72) Erfinder: Geittner, Peter, Dr., D-5100 Aachen (DE); Lydtin, Hans-Jürgen, Dr., D-5190 Stolberg (DE)
(74) Vertreter: Koch, Ingo

(56) Entgegenhaltungen:
- EP-A- 0 257 302
- EP-A- 0 266 178
- WO-A-88/06637
- DE-A- 3 611 663
- PATENT ABSTRACTS OF JAPAN, Band 11, Nr. 43 (C-402)[2490], 7. Februar 1987; & JP-A-61 207 572
- PATENT ABSTRACTS OF JAPAN, Band 9, Nr. 284 (E-357)[2007], 12. November 1985; & JP-A-60 124 928
- PATENT ABSTRACTS OF JAPAN, Band 12, Nr. 450 (C-547)[3297], 25. November 1988; & JP-A-63 176 463
- ANGEWANDTE CHEMIE, Band 25, Nr. 3, März 1986, Seiten 197-296, VCH Verlagsgesellschaft mbH, Weinheim, DE; T.P. MARTIN: "Cluster beam chemistry - from atoms to solids"

## Beschreibung

Die Erfindung betrifft ein Verfahren zur Herstellung von Festkörpern durch Beschichten eines Substrats unter Verwendung mindestens eines Ausgangsmaterials, das in die Form von Clustern gebracht wird.

Unter Clustern sind submikroskopische Festkörperpartikel mit geometrischen Abmessungen im Bereich einiger Nanometer bis einiger hundert Nanometer, typischerweise im Bereich von 1 bis 100 nm, zu verstehen, sowie Agglomerate derartiger Partikel mit Abmessungen bis zu 1 µm.

Verfahren der eingangs genannten Art sind z.B. aus GB-A-1 541 798 und DE-B-2 721 198, aus DE-C-3 335 107, DE-A-3 611 663, DE-C 3 628 443 und aus EP-B-0 051 639 bekannt. Den bekannten Verfahren ist gemeinsam, daß die Cluster, dort auch Mikrokeime, Teilchen oder Partikel genannt, als solche auf dem Substrat abgeschieden werden. Dies hat den Nachteil, daß poröse Schichten entstehen, die zur Herstellung kompakter Schichten ein Sintern erfordern, also einen zusätzlichen Verfahrensschritt. Das Sintern bringt die Gefahr einer Kontamination der Schichten mit sich. Die beim Sintern erforderlichen hohen Temperaturen können zu einem Wiederverdampfen abgeschiedenen Materials und/oder zu Umlagerungen und Diffusion innerhalb der Schichten und somit zu Strukturveränderungen führen. Außerdem besteht die Gefahr, daß während der Abscheidung eine Sedimentation auftritt, d.h. eine Teilchengrößenseparation, welche zu unerwünschten Inhomogenitäten im abgeschiedenen Material führt.

Den aus DE-C-3 335 107, DE-A-3 611 663, DE-C 3 628 443 und EP-B-0051 639 bekannten Verfahren ist gemeinsam, daß sie im Vakuum durchgeführt werden. Dies hat den Nachteil, daß Einschränkungen bezüglich Geometrie und Zusammensetzung der abgeschiedenen Schichten auftreten können.

Der Erfindung liegt die Aufgabe zugrunde, ein Verfahren zu schaffen, durch das kompakte Festkörper hergestellt werden, die definiert strukturiert sind und keinen Einbau von Fremdmolekülen aufweisen.

Diese Aufgabe wird erfindungsgemäß dadurch gelöst, daß die Cluster zunächst durch Energiezufuhr in ihre molekularen bzw. atomaren Bestandteile aufgelöst und daß danach die Bestandteile in Form kompakter Schichten auf dem Substrat abgeschieden werden.

Die Cluster werden vorzugsweise mit einem Trägergasstrom dosiert. Dies hat den Vorteil, daß der Ort der Clusterherstellung räumlich vom Ort der Auflösung und Abscheidung getrennt werden kann und alle Vorteile von Gasphasendosierverfahren (Mischen, Transport) auch für Cluster genutzt werden können.

Erfindungsgemäß können zur Herstellung der Cluster reine feste oder flüssige Ausgangsmaterialien (Elemente und/oder Verbindungen) in inerter (z.B. Edelgase), nicht reaktiver (z.B. H₂ CO, N₂) oder reaktiver (z.B. O₂, Cl₂, F) Atmosphäre herangezogen werden, typischerweise in einem Druckbereich von 1 hPa bis Atmosphärendruck. Für den Fall der Clustererzeugung in inerter Umgebung können Kontaminationen während der späteren Abscheidung wetestgehend ausgeschlossen werden.

Vorzugsweise werden als Ausgangsmaterialien reine Nichtmetall-Elemente, Metalle, Übergangsmetalle und Seltene Erden, und deren Oxide und Sulfide, verwendet.

Das erfindungsgemäße Verfahren gestattet es, als Ausgangsmaterialien auch bei Temperaturen unterhalb 200°C schwerflüchtige reine Stoffe zu verwenden. Damit hat das erfindungsgemäße Verfahren einen entscheidenden Vorteil gegenüber den bekannten CVD-Verfahren. Die Vorteile dieser Verfahren liegen in der Verwendung hochreiner gasförmiger Ausgangsstoffe, deren exakter Mischung und Dosierung in der Gasphase sowie dem kontaminationsfreien Transport dieser Gasgemische in die Reaktionszone; die in der CVD-Reaktion gebildeten kondensationsfähigen Reaktionsprodukte können dann entweder homogen in der Gasphase (in Form von Ruß oder Clustern) oder auch auf ausgedehnten Substratflächen (in Form von kompakten Schichten) mit hoher Reinheit abgeschieden werden. Eine definierte Variation der Gasphasenzusammensetzung bei der Abscheidung mehrerer aufeinanderfolgender Schichten (Mehrfachschichtenstruktur) ermöglicht dann eine exakte Variation bzw. Strukturierung der Materialeigenschaften des abgeschiedenen Festkörpers. Die erforderliche Verwendung gasförmiger Ausgangsstoffe stellt jedoch gleichzeitig eine wesentliche Einschränkung der bekannten CVD-Verfahren dar.

Der Anwendungsbereich des erfindungsgemäßen Verfahrens ist demgegenüber nicht auf Materialsysteme beschränkt, deren Ausgangsmaterialien bei Raumtemperatur gasförmig vorliegen bzw. einen ausreichend hohen Dampfdruck besitzen. Eine Erhöhung des Dampfdrucks schwerflüchtiger (z.B. flüssiger oder fester) Stoffe durch Aufheizen, die in der Regel einen hohen apparativen Aufwand bezüglich der Vermeidung von Rekondensationsvorgängen im Transportweg, z.B. eine Heizung des gesamten Dosierungs- und Transportsystems, erfordert und simultan die Gefahr beinhaltet, daß thermische Reaktionsabläufe partiell bereits im Vorratsgefäß oder auf dem Transportweg zum Reaktor auftreten, ist erfindungsgemäß nicht erforderlich. In der Praxis wird demzufolge der Bereich verwendbarer Ausgangsstoffe mit niedrigen Dampfdrucken sehr erweitert. Ein Ausweichen auf organische Verbindungen mit hohem Dampfdruck und niedriger Zerfallstemperatur, wie es im Bereich der MOCVD (Metal Organic CVD) praktiziert wird, ist erfindungsgemäß ebenfalls nicht erforderlich. Derartige organische Verbindungen bringen wachsende Probleme bezüglich Handhabung und Entsorgung (stark toxische Substanzen) und Kontamination der abgeschiedenen Materialien mit Reaktions-Nebenprodukten (wie z.B. Wasserstoff- und Kohlenstoffeinbau) mit sich. Nicht zuletzt stehen durch die Erfindung für viele Materialsysteme - wie z.B. die Elemente der 1. und 2. Gruppe des Periodensystems - für die Beschichtung geeignete Ausgangsstoffe zur Verfügung.

Ein weiterer Nachteil der bekannten CVD-Verfahren mit rein thermischer Reaktionsaktivierung besteht bei der Abscheidung mehrkomponentiger oder dotierter Festkörper darin, daß aufgrund unterschiedlich starker Molekülbindungen der Zerfall der gasförmigen Verbindungen nicht gleichzeitig erfolgt. Dies führt in aller Regel zu einem Festkörper, dessen Zusammensetzung von der Position des Substrates im Reaktor abhängt. Eine weitere Einschränkung thermischer CVD-Verfahren bei der Herstellung kompakter Festkörper (z.B. epitaktischer Schichten) ist die Notwendigkeit, homogene Gasphasenreaktionen mit nachgeschalteter homogener Keimbildung zu vermeiden. Die Einschränkung besteht hier in der Wahl der Temperatur, die so zu legen ist, daß im wesentlichen nur Reaktionen auf der Substratoberfläche zugelassen sind. Die Folgen dieser Einschränkung sind extrem niedrige Abscheidungsgeschwindigkeiten und lange Kontaminationszeiten. Eine Möglichkeit, diese Nachteile zu umgehen, ist mit dem PCVD-Verfahren gegeben. Mit Hilfe dieses Verfahrens ist es möglich, exakt dotierte Gleichgewichts- und Nichtgleichgewichts-Festkörperstrukturen, z.B. für Lichtleitfasern und Wolfram-Thorium-Kathoden, mit ortsunabhängiger Zusammensetzung auf ausgedehnten Substraten abzuscheiden. Allerdings hat sich herausgestellt, daß dies bei niedrigen Substrattemperaturen zum unerwünschten Einbau von Molekülresten (Cl, H, C) in den Festkörper führt. In vielen Anwendungsfällen sind die dadurch hervorgerufenen Strukturstörungen nicht tolerierbar; diese können nur systemabhängig, durch Anhebung der Substrattemperatur auf Werte zwischen 500°C und mehr als 1000°C, vermieden werden. Auch alle diese Nachteile werden durch das erfindungsgemäße Verfahren vermieden.

Die erfindungsgemäße Clustererzeugung erfolgt lokalisiert und unmittelbar über einer erhitzten Oberfläche des eingesetzten Ausgangsmaterials, vorzugsweise in einer bezüglich der Zustandsparameter (Art, Druck, Temperatur) bekannten und bezüglich des Flusses genau definierten Gasströmung. Obwohl die klassische Verdampfung des Ausgangsmaterials bei hohen Temperaturen atomar erfolgt, tritt die gewünschte Clusterbildung am Rand der lokalisierten Hochtemperaturzone bei Gastemperaturen ein, die auch einen Transport des Gas-Cluster-Gemisches, d.h. eines Aerosols, ohne die zuvor angesprochenen Nachteile bekannter Verfahren ermöglichen. Durch die erfindungsgemäße Maßnahme kann die "scheinbare Löslichkeit" von schwerflüchtigen Elementen oder Verbindungen bei den zulässigen Transporttemperaturen um Größenordnungen über die für diese Temperaturen typischen Dampfdruckwerte angehoben werden. Unter "scheinbarer Löslichkeit" wird hier der Dampfdruckwert verstanden, der sich einstellt, wenn man die in einem gegebenen Gasvolumen enthaltenen Cluster wieder in ihre Elementarbausteine (Atome, Moleküle) zerlegen würde.

Die Erzeugung der Cluster erfolgt vorzugsweise durch Laserverdampfung, auf thermischem Wege oder auch beispielsweise über ein PCVD-Verfahren. Die Herstellung von Festkörper- oder Flüssigkeitsclustern kann somit nach unterschiedlichen, aus der Literatur bekannten Verfahren erfolgen; als Beispiele seien thermische Verdampfung mit CO₂-Lasern, Ablation von Polymeren mit UV-Lasern, die Dosierung von submikroskopischen Flüssigkeitströpfchen in eine Gasphase (Tintenstrahl-Verfahren) und klassisch thermische Flammenhydrolyse- bzw. CVD-Verfahren genannt. Das breite Spektrum dieser Verfahren liefert insgesamt die Möglichkeit, Cluster aus unterschiedlichsten Materialien (reine Metalle, Oxide, Flüssigkeiten usw.) herzustellen; die geometrischen Abmessungen der Cluster können dabei den eingangs erwähnten Bereich von einigen Nanometer bis zu einem Mikrometer überdecken, wobei die Größenverteilungen verfahrensspezifisch durch Maßnahmen wie z.B. adiabatische Expansion über Hochdruckdüsen ins Vakuum, Injektion in Puffergasatmosphären und Ausfrieren auf gekühlten Substraten einstellbar sind. Bei der besonders vorteilhaften Clustererzeugung durch PCVD sind deutlich von den für die Lichtleitfaser-Herstellung optimalen PCVD-Parametern abweichende Bedingungen zweckmäßig (höhere Drucke, niedrigere Temperaturen und Plasmaleistungen).

Die entsprechend der zuvor beschriebenen Ausführungsform der Erfindung in einem separaten Reaktionsraum hergestellten Cluster werden im nächsten Verfahrensschritt in einem Trägergasstrom über eine Transportleitung dem eigentlichen Reaktionsraum zugeführt, in dem sie wiederaufgelöst und als monokomponentiges Material abgeschieden werden. Hauptprobleme bei diesem Transport liegen insbesondere in möglichen Verlusten von Clustermaterial durch Ablagerung an den Innenwänden der Transportleitung sowie in Verbindung damit auftretenden elektrostatischen Aufladungseffekten, die eine Agglomeration der Cluster untereinander verstärken und damit die Homogenität der Gasphasenbeladung reduzieren.

Als Maßnahmen zur weitestmöglichen Reduzierung von Sedimentation und Kontakten zwischen Pulverteilchen und Leitungswänden sind die Anwendung von ringförmig den Trägergasstrom umschließenden Schutzgasströmen, das Aufheizen der Leitungswände sowie das Anlegen von Ultraschallfedern an die Transportleitungen bekannt. Bekannt ist ebenfalls, daß durch Aufprägung erhöhter radialer Temperaturgradienten in der umgebenden Gasphase die relevanten treibenden thermophoretischen Kräfte und damit die radiale Bewegungskomponente des Teilchenensembles vergrößert werden kann; Beispiele für die Anwendung dieser Technik zur Erhöhung der Sedimentationsgeschwindigkeiten für die SiO₂-Ruß-Abscheidung bei thermischen Innenbeschichtungs-Verfahren sind die Verfahrensmodifikationen der plasma- und laserunterstützten MCVD (PMCVD und LMCVD, z.B. DE-A-2 712 993). Eine derartig erreichbare Erhöhung der Driftgeschwindigkeiten für die Teilchen zur Rohrwand hin ist im vorliegenden Fall allerdings offensichtlich keine geeignete Maßnahme zur berührungslosen Führung des Clusterstroms im Transportweg.

Diese Probleme werden erfindungsgemäß besonders wirkungsvoll dadurch gelöst, daß zur Führung und Fokussierung der Cluster auf der Achse des Trägergasstroms ein achsparallel ausgerichteter Laserstrahl mit ringförmiger, zur Achse konzentrischer Intensitätsverteilung - mit maximaler Energiedichte im den Cluster-Trägergasstrom umgebenden Außenbereich und minimaler Energiedichte auf der Strahlachse - verwendet wird. Verluste durch Reaktion, Sedimentation oder Abscheidung im Transportweg vor Erreichen der CVD-Reaktionszone können also durch den Einsatz eines leistungsstarken Lasers gering gehalten werden, wobei der Laserstrahl koaxial zum Clusterstrom ausgerichtet und dessen radiale Intensitätsverteilung durch optische Komponenten, z.B. Strahlaufweiter, Ring-Aperturblenden oder Linsen, so vorgegeben wird, daß die optische Leistungsdichte im den Clusterstrom umgebenden Außenbereich maximal und im Innenbereich - insbesondere im Zentrum des Clusterstroms - deutlich reduziert und vorzugsweise Null ist. Bei Verwendung geeigneter Laser (z.B. CO₂-Laser) kann dann über die Absorption optischer Leistung in der Träger- und Umgebungsgasphase ein peripher weitgehend homogenes Temperaturfeld mit ausgeprägten radialen Temperaturgradienten erzeugt werden, deren Richtung eine Verstärkung der auf die Cluster wirkenden thermophoretischen Kräfte zur Strahlachse hin und damit eine 'Fokussierung' des Clusterstroms bewirkt. Für den Fall, daß die Cluster im Bereich der Emissionswellenlänge des Lasers absorbieren, wird der Effekt der thermophoretischen Fokussierung noch zusätzlich dadurch unterstützt, daß in den Außenbereich (mit hoher Leistungsdichte) driftende Cluster direkt vom Laserstrahl aufgeheizt und - bei entsprechend hoher Absorption bzw. Laserleistung - sogar verdampft werden können (wobei eine Rekondensation vorzugsweise im Bereich niedrigerer Gastemperaturen - d.h. im Zentralbereich des Clusterstroms - stattfinden kann).

Weitere spezifische Vorteile der erfindungsgemäß bevorzugten Anwendung eines Lasers liegen in der Flexibilität der Anpassung der Temperaturfelder - bezüglich Geometrie und Größe der radialen Temperaturgradienten - an die Dimensionen des vorgegebenen Clusterstroms; diese Anpassung kann über variable Strahlaufweitungsoptiken und Laserleistungen in besonders einfacher Weise vorgenommen werden. Bei schwacher Fokussierung oder Aufweitung des ringförmigen Laserstrahls kann der Clusterstrom über die oben beschriebenen Mechanismen sogar in gewissen Grenzen bezüglich seines Querschnitts längs der Ausbreitungsrichtung verkleinert oder vergrößert werden (schwach konvergentes oder divergentes Clusterstromprofil).

Insgesamt kann in einfacher Weise ein Kontakt der Cluster mit den Innenwandungen der Transportleitung wirkungsvoll verhindert und der Clusterstrom so weitgehend berührungslos in den eigentlichen Reaktionsraum eingebracht werden.

Besonders vorteilhaft ist es, die Führung des Clusterstroms in einer Leitung vorzunehmen, die zwischen dem Ort der Clustererzeugung und dem Ort der Abscheidung eine ansteigende Wandtemperatur aufweist. Damit wird ebenfalls eine Clusterabscheidung auf den Wandungen der Transportleitungen vermieden.

Die Cluster werden vorzugsweise in eine Plasmazone eingeleitet und dort aufgelöst. Die Erzeugung der Cluster und deren Dosierung in den Trägergasstrom wird somit außerhalb der für die Auflösung der Cluster verwendeten Reaktionszone vorgenommen. Die Beladung des Gasstroms mit Clustern erlaubt hohe Massentransportraten für das abzuscheidende Material.

Bei einer Abwandlung dieser bevorzugten Ausführungsform der Erfindung findet in der Plasmazone eine Reaktion statt, die sich von bekannten CVD-Reaktionen dadurch unterscheidet, daß als Ausgangsmaterialien keine flüchtigen gasförmigen Verbindungen, sondern Cluster verwendet werden, die dosiert in einen Trägergasstrom eingegeben und mit diesem in die Plasmazone transportiert werden. In der Reaktionszone, vorzugsweise einer nichtisothermen Niederdruck-Mikrowellen-Plasmaentladung, werden die Cluster dann aufgelöst und direkt auf Substraten abgeschieden.

Im Verfahrensschritt des Auflösens werden die Cluster erfindungsgemäß bezüglich der primär vorliegenden Clustergrößenverteilungen und -Materialzusammensetzungen gezielt verändert. Dabei bietet insbesondere die Auflösung und Abscheidung von Clustermaterial mit Hilfe von PCVD (Plasma induced CVD)- und LICVD (Laser induced CVD)-Bedingungen sämtliche spezifische Vorteile dieser Verfahren bezüglich geometrischer Uniformität, Strukturierung und Reinheit der Materialien.

Bei der Auflösung der Cluster und Abscheidung des Clustermaterials auf Substraten in Form kompakter, homogener und uniformer Schichten wird ein unter typischen PCVD-Bedingungen auftretendes, experimentell erstmals beobachtetes Verhalten in der Art ausgenutzt, daß für ausreichend kleine Clusterabmessungen die Clustertemperatur während der Aufenthaltsdauer der Partikel im Mikrowellenplasma durch Energieaufnahme durchaus soweit erhöht werden kann, daß eine Verdampfung bzw. Auflösung der Cluster im Bereich der PCVD-Plasmazone möglich ist. Dieses Verhalten geht offensichtlich über den bisherigen Kenntnisstand, daß unter optimalen PCVD-Bedingungen eine homogene Abscheidungsreaktion - d.h. Rußbildung in der Gasphase - nicht auftritt, deutlich hinaus. Mögliche Energieübertragungsmechanismen sind dabei für Cluster mit geringer elektrischer Leitfähigkeit (z.B. SiO₂) die Aufnahme von Rekombinationsenergie bei Stößen zwischen hochangeregten/dissoziierten O₂-Molekülen und Clustern und für Cluster mit hoher elektrischer Leitfähigkeit außerdem die direkte Absorption von Mikrowellenenergie im elektrischen Feld des plasmagenerierenden Mikrowellenresonators. Unabhängig von den speziellen Energieübertragungsmechanismen kann jedoch in beiden Fällen nach dem erfindungsgemäßen Verfahren eine Auflösung der Cluster mit anschließender Abscheidung des Clusterinhalts auf Substraten erreicht werden.

Vorteile ergeben sich bei dieser Auflösung von Clustern mit darauffolgender Abscheidung insbesondere dadurch, daß neben der Möglichkeit der Verwendung nahezu beliebiger Materialien auch hier sämtliche PCVD-spezifische Vorteile bezüglich geometrischer Uniformität, Strukturierungsgenauigkeit und Reinheit der abgeschiedenen Materialschichten in vollem Umfang genutzt werden können.

Neben der Wiederverdampfung mit Hilfe eines Plasmas kommt auch eine Verdampfung durch Hochleistungslaser in Betracht.

Die Erfindung wird an Hand einer Zeichnung und einiger Ausführungsbeispiele näher erläutert. In der Zeichnung zeigen in schematischer Darstellung
- Fig. 1: eine Vorrichtung zur Clustererzeugung durch Laserstrahlung,
- Fig. 2: eine Vorrichtung zur Clustererzeugung durch Mikrowellen und
- Fig. 3: eine Vorrichtung zur Clusterauflösung und Erzeugung kompakter Schichten.

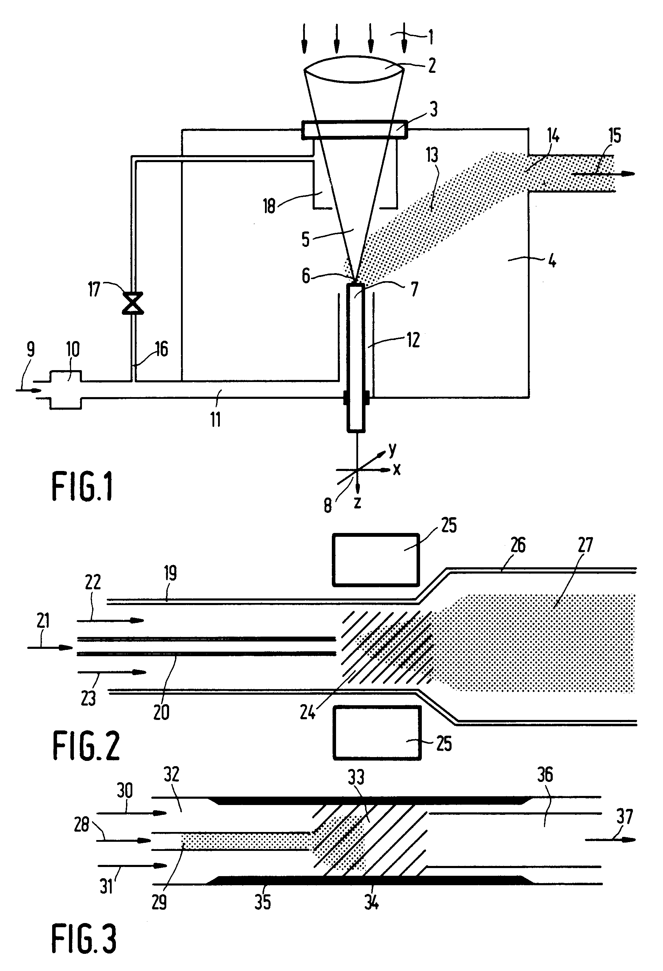

Fig. 1 zeigt das Schema einer Vorrichtung zur Erzeugung von Clustern und zu deren Eindosierung in einen bezüglich seines Volumenflusses definierten Trägergasstrom. Die Vorrichtung gestattet es, von einem Laser (nicht dargestellt) kommende Laserstrahlen 1 über eine Sammellinse 2 und ein Eintrittsfenster 3, das für die Laserstrahlen transparent ist und in eine Wandung eines Verdampfungsgefäßes 4 eingelassen ist, zu einem Strahlengang 5 zu fokussieren, der in einem Brennpunkt 6 auf einen Formkörper 7 auftrifft. Der Formkörper besteht aus einem zu verdampfenden Ausgangsmaterial und ist im Verdampfungsgefäß angeordnet.

Die durch diese Maßnahme erzeugte hohe Energiedichte führt bei genügender Absorption der Laserstrahlung zu einer lokalen Temperaturerhöhung der Oberfläche des Formkörpers 7 und einer Verdampfung von Ausgangsmaterial in die Gasphase. Wichtig dabei ist, daß die Verdampfung aus arteigener Umgebung heraus stattfindet und eine möglicherweise schädliche Kontamination mit Verdampfungsgefäßmaterialien gänzlich ausgeschlossen wird.

Der gleichmäßige Abtrag von Ausgangsmaterial wird durch eine Relativbewegung des Formkörpers 7 zum optischen Strahlengang 5 gewährleistet, wobei die Relativbewegung durch eine symbolisch angedeutete Einrichtung 8 bewirkt wird, deren Bewegungsrichtungen mit x, y und z bezeichnet sind.

Das sich zunächst durch Verdampfung in atomarer bzw. molekularer Form von der Oberfläche des Formkörpers 7 lösende Ausgangsmaterial gelangt in einen Gasstrom (Pfeil 9), der über einen Gasflußzähler 10 und eine Leitung 11 einer düsenähnlichen Einrichtung 12 zugeführt wird, durch die der Gasstrom derart an der erhitzten Oberfläche des Formkörpers 7 entlanggeführt wird, daß eine Rekondensation des gerade verdampften Materials auf der Oberfläche selbst weitestgehend ausgeschlossen wird. Dicht oberhalb der dem optischen Strahlengang 5 zugewandten Oberfläche des Formkörpers und abseits vom Brennpunkt 6 findet dann in der Gasphase die erwünschte Bildung von Clustern 13 statt; diese werden von dem Gasstrom zu einem Ausgang 14 des Verdampfungsgefäßes 4 mitgerissen, was durch einen Pfeil 15 angedeutet ist. Zur Verhinderung einer Belegung des Eintrittsfensters 3 mit Clustern wird ein Teilstrom des Gasstroms über eine Zweigleitung 16 mit einem Ventil 17 als Spülgas in einen Schutzraum 18 eingeführt.

### Beispiel 1: Erzeugung von Clustern aus SiO₂ mit einem Hochleistungs-CO₂-Laser und Maßnahmen zu ihrer kontinuierlichen Dosierung in einen Trägergasstrom

Mit der in Fig. 1 dargestellten Vorrichtung wurden unter Anwendung eines 800 W-CO₂-Lasers, einer ZnSe-Optik, eines O₂-Trägergasstroms von 500 sccm (Standard-Kubikzentimeter pro Minute) und eines relativ zum Strahlengang verschobenen SiO₂-Plättchens mit den Abmessungen 3 mm x 10 mm x 300 mm gleichmäßige Verdampfungsraten von 0,1 g SiO₂ pro Minute erzielt. Praktisch 100% des verdampften Materials lag in Form von Clustern, d.h. submikroskopische Teilchen mit Durchmessern von etwa 10 bis etwa 100 nm, vor, von denen etwa 90% aus dem Verdampfungsgefäß ausgetragen wurden. Die Verdampfung des Materials und die Clustererzeugung fanden unter einem Druck von 200 hPa statt.

Während das vorstehende Ausführungsbeispiel für eine direkte Überführung schwerflüchtiger Elemente und Verbindungen - ohne wesentliche chemische Veränderungen, d.h. Verdampfung von SiO₂ in O₂ oder Ar; Verdampfung von Na in He, Kr usw. - steht, liegt dem folgenden Ausführungsbeispiel der Gedanke zugrunde, in einem Gas, das flüchtige Verbindungen enthält, mit einer unvollkommenen Plasmaentladung Cluster zu erzeugen. Die im folgenden Beispiel erläuterte Fig. 2 zeigt eine Vorrichtung zur Durchführung dieses Konzepts.

### Beispiel 2: Erzeugung von Clustern mit Hilfe eines Mikrowellenplasmas

Durch ein in einem Quarzrohr 19 zentral angeordnetes Quarzrohr 20 wurde SiCl₄ (Pfeil 21) mit einer Flußrate von etwa 150 sccm gleichzeitig mit 400 sccm O₂ (Pfeile 22 und 23), die im Zylinderringraum zwischen den Rohren 19 und 20 parallel zum SiCl₄ strömten, in eine durch ein Mikrowellenplasma gebildete Reaktionszone 24 eingeführt. Die von einem Mikrowellenresonator 25 abgegebene Leistung betrug 400 W. Die eingekoppelte Plasmaleistung, der Gesamtdruck von 16 hPa und der Innendurchmesser von 26 mm des Quarzrohres 26 wurden dabei so gewählt, daß eine Abscheidung kompakter SiO₂-Schichten, wie sie bei der Herstellung von Lichtleitfasern nach dem PCVD-Verfahren vorgenommen wird (EP-B-0 023 066), nicht stattfand. Vielmehr wurde durch die schwache eingekoppelte Leistung lediglich ein Molekülzerfall angeregt, die naturgegebene (thermodynamisch geforderte) homogene Bildung von Keimen und Clustern 27 in der Gasphase jedoch nicht unterdrückt. Das Ergebnis dieser Maßnahmen ist eine erhebliche Produktion von Clustern mit typischen Durchmessern im Bereich von 10 bis 100 nm (10 nm - Elementarteilchen, 100 nm - Agglomerate von Elementarteilchen). Unter den angegebenen Versuchsbedingungen lag die SiO₂-Clusterausbeute bei etwa 35%, bezogen auf das eingesetzte Material.

### Beispiel 3: Herstellung kompakter Schichten durch Clusterauflösung in der Gasphase und molekulare bzw. atomare Diffusion zu und Kondensation auf einem Substrat

Als Ausgangsmaterial diente ein Aerosol, bestehend aus SiO₂-Clustern und Sauerstoffgas. Typische Abmessungen der SiO₂-Cluster lagen zwischen 10 und 100 nm. Die Cluster entsprachen den in den Beispielen 1 und 2 erwähnten SiO₂-Clustern.

Gemäß Fig. 3 wurde ein mit etwa 0,1 g SiO₂/400 sccm O₂ beladener Gasstrom (Pfeil 28) wurde über ein zentrales Quarzrohr 29 parallel mit etwa 600 sccm O₂ (Pfeile 30 und 31), die durch einen Ringraum 32 zugeführt wurden, in eine durch ein Mikrowellenplasma gebildete Reaktionszone 33 eingeleitet. Eine hohe eingekoppelte Leistung von 5 kW bewirkte eine praktisch vollständige Auflösung der SiO₂-Cluster und eine molekulare Kondensation in Form einer etwa 0,5 mm dicken kompakten Schicht 34 auf einem, während der Versuchsdauer von 30 Minuten 20mal hin- und herbewegten Substratrohr 35. Restgase wurden mit einer Pumpe (nicht dargestellt) durch ein Absaugrohr 36, das eine mögliche Restkontamination der abgeschiedenen Schichten verhindert, abgeführt (Pfeil 37).

## Patentansprüche

1. Verfahren zur Herstellung von Festkörpern durch Beschichten eines Substrats unter Verwendung mindestens eines Ausgangsmaterials, das in die Form von Clustern gebracht wird, dadurch gekennzeichnet, daß die Cluster zunächst durch Energiezufuhr in ihre molekularen bzw. atomaren Bestandteile aufgelöst und daß danach die Bestandteile in Form kompakter Schichten auf dem Substrat abgeschieden werden.

2. Verfahren nach Anspruch 1,
dadurch gekennzeichnet, daß die Cluster mit einem Trägergasstrom dosiert werden.

3. Verfahren nach Anspruch 1 oder 2,
dadurch gekennzeichnet, daß als Ausgangsmaterialien reine Nichtmetall-Elemente, Metalle, Übergangsmetalle und Seltene Erden, und deren Oxide und Sulfide, verwendet werden.

4. Verfahren nach Anspruch 1, 2 oder 3,
dadurch gekennzeichnet, daß als Ausgangsmaterialien bei Temperaturen unterhalb 200°C schwerflüchtige reine Stoffe verwendet werden.

5. Verfahren nach Anspruch 1, 2, 3 oder 4,
dadurch gekennzeichnet, daß die Erzeugung der Cluster durch Laserverdampfung oder auf thermischem Wege erfolgt.

6. Verfahren nach Anspruch 1, 2, 3 oder 4,
dadurch gekennzeichnet, daß zur Erzeugung der Cluster ein PCVD-Verfahren angewendet wird.

7. Verfahren nach Anspruch 2,
dadurch gekennzeichnet, daß zur Führung und Fokussierung der Cluster auf der Achse des Trägergasstroms ein achsparallel ausgerichteter Laserstrahl mit ringförmiger, zur Achse konzentrischer Intensitätsverteilung - mit maximaler Energiedichte im den Cluster-Trägergasstrom umgebenden Außenbereich und minimaler Energiedichte auf der Strahlachse - verwendet wird.

8. Verfahren nach Anspruch 7, dadurch gekennzeichnet, daß der Laserstrahl mit Hilfe eines CO₂-Lasers erzeugt wird.

9. Verfahren nach Anspruch 7 oder 8, dadurch gekennzeichnet, daß der Laserstrahl durch eine variable Strahlaufweitungsoptik geleitet ist.

10. Verfahren nach Anspruch 7, dadurch gekennzeichnet, daß der Clusterstrom in einer Leitung geführt wird, deren Temperatur in Strömungsrichtung zunimmt.

11. Verfahren nach Anspruch 1, 2 oder 7,
dadurch gekennzeichnet, daß die Cluster in eine Plasmazone eingeleitet werden.

12. Verfahren nach Anspruch 11,
dadurch gekennzeichnet, daß die Cluster in eine PCVD-Reaktionszone eingeleitet werden.

13. Verfahren nach Anspruch 11,
dadurch gekennzeichnet, daß die Cluster mit einem Hochleistungslaser aufgelöst werden.

## Claims

1. A method of manufacturing solid bodies by coating a substrate, making use of at least one starting material which is supplied in the form of clusters, characterized in that the clusters are first disintegrated into their molecular or atomic constituents by the supply of energy and then that the constituents are deposited on the substrate in the form of compact layers.

2. A method as claimed in Claim 1, characterized in that a carrier-gas stream is used to dose the clusters.

3. A method as claimed in Claim 1 or 2, characterized in that pure non-metallic elements, metals, transition metals and rare earths, and the oxides and sulphides thereof, are used as the starting materials.

4. A method as claimed in Claim 1, 2 or 3, characterized in that difficultly volatile pure substances are used as the starting materials at temperatures below 200° C.

5. A method as claimed in Claim 1, 2, 3 or 4, characterized in that the manufacture of the clusters is carried out by means of laser evaporation or in a thermal manner.

6. A method as claimed in Claim 1, 2, 3 or 4, characterized in that a PCVD process is used to manufacture the clusters.

7. A method as claimed in Claim 2, characterized in that for conveying the clusters and focusing them on the axis of the carrier-gas stream, a laser beam is used which is oriented so as to be parallel to the said axis and which has an annular intensity distribution which is concentric with the axis, which laser beam has a maximum energy density in the outer region surrounding the cluster carrier-gas stream and a minimum energy density on the beam axis.

8. A method as claimed in Claim 7, characterized in that the laser beam is produced by using a C0₂ laser.

9. A method as claimed in Claim 7 or 8, characterized in that the laser beam is passed through a variable optical beam expansion means.

10. A method as claimed in Claim 7, characterized in that the cluster stream is led through a pipe whose temperature increases in the direction of flow.

11. A method as claimed in Claim 1, 2 or 7, characterized in that the clusters are introduced into a plasma zone.

12. A method as claimed in Claim 11, characterized in that the clusters are introduced into a PCVD reaction zone.

13. A method as claimed in Claim 11, characterized in that the clusters are disintegrated by means of a high-power laser.

## Revendications

1. Procédé de fabrication de corps solides par revêtement d'un substrat en utilisant au moins un matériau de départ qui est fourni en forme d'amas, caractérisé en ce que
les amas sont d'abord décomposés par apport d'énergie en leurs constituants moléculaires respectivement atomiques pour être déposés ensuite sur le substrat en forme de couches compactes.

2. Procédé selon la revendication 1, caractérisé en ce que les amas sont dosés à l'aide d'un courant de gaz porteur.

3. Procédé selon la revendication 1 ou 2, caractérisé en ce qu'on utilise comme matériaux de départ des éléments non-métalliques purs, des métaux, des métaux de transition et des terres rares, ainsi que leurs oxydes et leurs sulfures.

4. Procédé selon la revendication 1, 2 ou 3, caractérisé en ce qu'on utilise comme matériaux de départ à des températures inférieures à 200°C des substances pures peu volatiles.

5. Procédé selon la revendication 1, 2, 3 ou 4, caractérisé en ce que les amas sont formés par évaporation laser ou par voie thermique.

6. Procédé selon la revendication 1, 2, 3 ou 4, caractérisé en ce que les amas sont formés par un procédé PCVD.

7. Procédé selon la revendication 2, caractérisé en ce que pour guider et focaliser les amas sur l'axe du courant de gaz porteur on utilise un rayon laser aligné parallèlement audit axe et présentant une distribution d'intensité annulaire concentrique par rapport à l'axe - qui présente une densité énergétique maximale dans la région extérieure entourant le courant de gaz porteur/d'amas et une densité énergétique minimale à l'axe du rayon.

8. Procédé selon la revendication 7, caractérisé en ce que le rayon laser est engendré à l'aide d'un laser CO₂.

9. Procédé selon la revendication 7 ou 8, caractérisé en ce que le rayon laser est amené à passer par une optique d'élargissement de faisceau.

10. Procédé selon la revendication 7, caractérisé en ce que le courant d'amas est transporté dans une canalisation dont la température va en augmentant dans le sens de propagation.

11. Procédé selon la revendication 1, 2 ou 7, caractérisé en ce que les amas sont introduits dans une zone de plasma.

12. Procédé selon la revendication 11, caractérisé en ce que les amas sont introduits dans une zone de réaction PCVD.

13. Procédé selon la revendication 11, caractérisé en ce que les amas sont dissous par un laser à haute puissance.
